Europäisches Patentamt

European Patent Office

Office européen des brevets

(11) Veröffentlichungsnummer: **0 332 955**
**A2**

## (12) EUROPÄISCHE PATENTANMELDUNG

(21) Anmeldenummer: 89103804.4

(22) Anmeldetag: 03.03.89

(51) Int. Cl.4: **H01L 29/743 , H01L 29/36 , H01L 29/08 , H01L 29/10 , H01L 21/225**

(30) Priorität: 15.03.88 DE 3808666

(43) Veröffentlichungstag der Anmeldung:
20.09.89 Patentblatt 89/38

(84) Benannte Vertragsstaaten:
CH DE FR GB LI SE

(71) Anmelder: **Siemens Aktiengesellschaft**
**Wittelsbacherplatz 2**
**D-8000 München 2(DE)**

(72) Erfinder: **Schwarzbauer, Herbert, Dr.rer.nat.**
**Kössener Strasse 13**
**D-8000 München 70(DE)**
Erfinder: **Kuhnert, Reinhold, Dr.Dipl.-Phys.**
**Dachauer Strasse 140d**
**D-8000 München 19(DE)**

(54) **Thyristor mit hoher positiver und negativer Sperrfähigkeit und Verfahren zu dessen Herstellung.**

(57) Thyristor, bei dem das p-Basisgebiet (2) durch einen ersten, sich in seinem Randbereich der Thyristoroberseite (1a) ganz allmählich annähernden planaren pn-Übergang (3) von der darunterliegenden n-Basis (14) getrennt ist. Der p-Emitter besteht aus einer an der Unterseite (1b) des Thyristors eingefügten, p-leitenden Schicht (11), die sich in einer den Thyristor seitlich begrenzenden, von der Unterseite (1b) bis zur Oberseite (1a) reichenden p-leitenden Seitenzone (15) fortsetzt, welche in eine an der Thyristoroberseite eingefügte p-leitende Halbleiterzone (17) übergeht. Letztere geht von dem an der Oberseite (1a) liegenden Teil der Seitenzone (15) aus, verläuft längs der Thyristoroberseite in Richtung auf den Randabschluß (4) des p-Basisgebiets (2) und ist durch einen sich der Oberseite (1a) ganz allmählich annähernden, zweiten planaren pn-Übergang (18) von der n-Basis (14) getrennt.

FIG 1

## Thyristor mit hoher positiver und negativer Sperrfähigkeit und Verfahren zu dessen Herstellung

Die Erfindung bezieht sich auf einen Thyristor nach dem Oberbegriff des Patentanspruchs 1 sowie auf Verfahren zu dessen Herstellung.

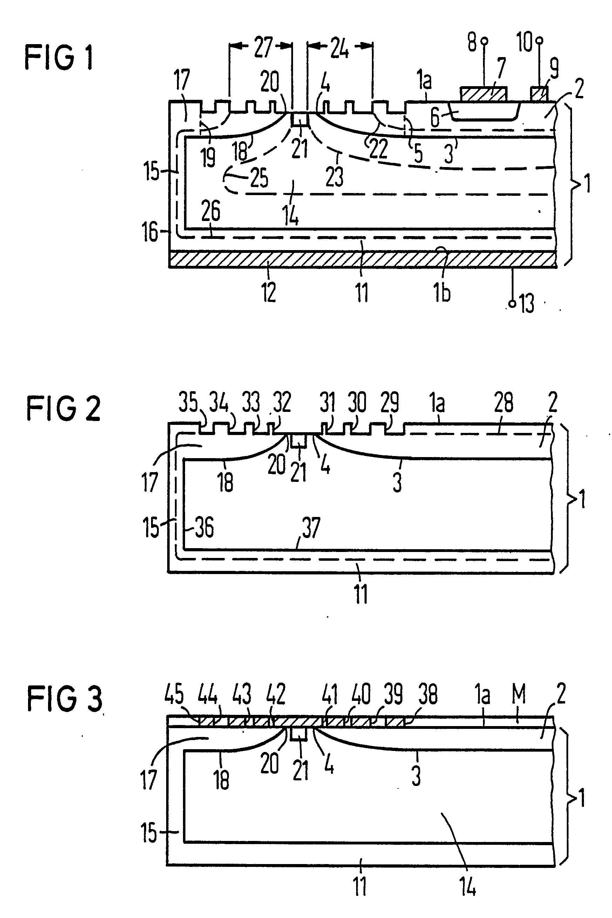

Ein Thyristor dieser Art ist aus dem "Thyristor-Handbuch" von A. Hoffmann und K. Stocker, Verlag Siemens AG, Berlin und München, 1965, S. 37 und 38, insbesondere Bild 8.1, bekannt. Wie in dem Buch von P. D. Taylor "ThyristorDdesign and Realization", Verlag John Wiley and Sons, New York, 1987, S. 28 - 35, insbesondere Fig. 2.1 und Fig. 2.4, beschrieben, ist beim Anlegen einer Blokkierspannung zwischen Anode und Kathode eines Thyristors, durch die die Anode auf ein höheres Potential gelegt wird als die Kathode, der pn-Übergang zwischen der n-Basis und der p-Basis in Sperrrichtung vorgespannt. Beim Anlegen einer Sperrspannung zwischen Anode und Kathode, durch die die Kathode auf ein höheres Potential gelegt wird als die Anode, ist dagegen der pn-Übergang zwischen der n-Basis und dem p-Emitter in Sperrrichtung vorgespannt. Überschreitet die angelegte Blockierspannung einen vorgegebenen Grenzwert, der die positive Sperrfähigkeit (forward blocking capability) des Thyristors bestimmt, so kommt es zu einem Durchbruch am pn-Übergang zwischen der n-Basis und der p-Basis, was zur Folge hat, daß der Thyristor ungewollt zündet und dadurch unter Umständen thermisch stark belastet wird. Falls andererseits die angelegte Sperrspannung einen vorgegebenen Grenzwert überschreitet, der die negative Sperrfähigkeit (reverse blocking capability) des Thyristors angibt, so erfolgt ein Lawinendurchbruch des pn-Übergangs zwischen der n-Basis und dem p-Emitter, der den Thyristor im allgemein thermisch überlastet und somit zerstört.

Die elektrische Feldstärke ist an den Stellen, an denen die oben erwähnten pn-Übergänge die Halbleiteroberfläche erreichen, durch den Einfluß von Oberflächenladungen und Randgeometrie überhöht. Dadurch tritt am Bauelementrand ein vorzeitiger Durchbruch auf bevor die Volumensperrfähigkeit erreicht ist. Daher ist man bestrebt, die an den Rändern der in Sperrrichtung vorgespannten pn-Übergänge auftretenden Oberflächenfeldstärken zu reduzieren.

Aus der EP-A 0 176 778 ist es bekannt, die oberflächenseitige Durchbruchspannung eines planaren pn-Übergangs, der ein in einen Halbleiterkörper eindiffundiertes Halbleitergebiet von dem übrigen Teil des Halbleiterkörpers trennt, dadurch zu erhöhen, daß eine Diffusionsmaske verwendet wird, die außerhalb einer das Halbleitergebiet lateral definierenden Öffnung mit kleineren zusätzlichen Öffnungen versehen ist, so daß sich beim Eindiffundieren des Dotierstoffes ein Dotierprofil ergibt, das sich mit zunehmendem Abstand vom Rand der das Halbleitergebiet definierenden Maskenöffnung der Grenzfläche des Halbleiterkörpers ganz allmählich annähert.

Der vorliegenden Erfindung liegt die Aufgabe zugrunde, einen Thyristor der eingangs genannten Art anzugeben, der trotz eines einfachen Aufbaues sowohl eine hohe positive als auch eine hohe negative Sperrfähigkeit besitzt. Das wird erfindungsgemäß durch eine Ausbildung nach dem kennzeichnenden Teil des Patentanspruchs 1 erreicht.

Der mit der Erfindung erzielbare Vorteil liegt insbesondere darin, daß die Randabschlüsse der beiden die positive und negative Sperrfähigkeit bestimmenden pn-Übergänge auf der Oberseite des Thyristor-Halbleiterkörpers angeordnet sind und daher in einfacher Weise so ausgebildet werden können, daß sie die gewünschten hohen Sperrfähigkeiten gewährleisten. Insbesondere steht trotz einer erzielbaren hohen negativen Sperrfähigkeit die gesamte Unterseite des Thyristor-Halbleiterkörpers als Kontaktfläche für eine Verbindung mit einer wär-meableitenden Substratscheibe, z.B. aus Molybdän, zur Verfügung. Weiterhin können die Randbereiche beider sperrender pn-Übergänge wegen ihrer Anordnung auf ein und derselben Thyristorseite z. B. durch Aufbringen von Passivierungsschichten aus amorphem Silizium, Glas oder SIPOS (semi-insulating polysilicon) oder durch Anwendung von Feldplatten usw. in wesentlich einfacherer Weise vor zu großen Oberflächenfeldstärken geschützt werden, als das bei den bekannten Thyristoren der Fall ist.

Der Anspruch 2 ist auf eine bevorzugte Weiterbildung der Erfindung gerichtet. Vorteilhafte Verfahren zur Herstellung eines Thyristors nach der Erfindung sind in den Patentansprüchen 3 bis 5 angegeben.

Die Erfindung wird nachfolgend anhand der Zeichnung näher erläutert. Dabei zeigt:

Fig. 1 einen erfindungsgemäßen Thyristor im Querschnitt,

Fig. 2 einen Zwischenschritt bei der Herstellung des erfindungsgemäßen Thyristors nach einem ersten Verfahren,

Fig. 3 einen Zwischenschritt bei der Herstellung des erfindungsgemäßen Thyristors nach einem zweiten Verfahren, und

Fig. 4 einen anderen erfindungsgemäßen Thyristor.

In Fig. 1 ist der Querschnitt eines Halbleiterkörpers 1, z.B. aus n-dotiertem Silizium mit einer Dotierungskonzentration von etwa $10^{13} cm^{-3}$, dargestellt, in den ein p-leitendes Basisgebiet 2 eingefügt ist. Dieses ist durch einen planaren pn-Übergang 3 vom übrigen Teil des Halbleiterkörpers 1 getrennt. Der pn-Übergang 3 verläuft im wesentlichen parallel zur Oberseite 1a des Halbleiterkörpers 1, nähert sich aber in seinem Randbereich ganz allmählich der Oberseite 1a an und erreicht diese in einer senkrecht zur Bildebene verlaufenden Linie 4, die die laterale Begrenzung des Basisgebiets 2 darstellt. Als Dotierstoff für das Basisgebiet 2 kommt z. B. Al, Ga oder B in Betracht, wobei die Dotierungskonzentration in dem rechts von der gestrichelten Linie 5 liegenden, zentralen Teil von 2 etwa $10^{18} cm^{-3}$ beträgt und sich innerhalb des links von 5 liegenden Teils von 2 in Richtung auf die laterale Begrenzung 4 ständig verringert, so daß sie bei 4 schließlich auf einen Wert von ungefähr $10^{13} cm^{-3}$ abgesunken ist. In das Basisgebiet 2 ist ein n-leitendes Emittergebiet 6 eingefügt, das an der Oberseite 1a des Halbleiterkörpers 1 von einer mit einem Kathodenanschluß 8 versehenen kathodenseitigen Elektrode 7 kontaktiert wird. Sind noch weitere n-leitende Emittergebiete in das Basisgebiet 2 eingefügt, so wird jedes derselben von einem zugeordneten Teil der kathodenseitigen Elektrode kontaktiert, wobei diese Teile untereinander leitend verbunden und an den Anschluß 8 geführt sind. Das Basisgebiet 2 wird von einer Gateelektrode 9 kontaktiert, die zum Zünden des Thyristors mit einem über einen Anschluß 10 zugeführten positiven Zündspannungsimpuls beaufschlagt wird. Der p-Emitter des Thyristors besteht aus einer in den Halbleiterkörper 1 an dessen Unterseite 1b eingefügten p-leitenden Halbleiterschicht 11, auf der eine anodenseitige Elektrode 12 aufgebracht wird, die mit einem Anodenanschluß 13 versehen ist. Der unterhalb des Basisgebiets 2 und oberhalb der Halbleiterschicht befindliche Teil 14 des Halbleiterkörpers 1 bildet die n-Basis des Thyristors.

Die p-leitende Halbleiterschicht 11 setzt sich in einer p-leitenden Seitenzone 15 fort, die in den Halbleiterkörper 1 an dessen seitlichem Rand 16 eingefügt ist und sich von der Unterseite 1b bis zur Oberseite 1a desselben erstreckt. Weiterhin ist eine in den Halbleiterkörper 1 an dessen Oberseite eingefügte, p-leitende Halbleiterzone 17 vorgesehen, die von dem an der Oberseite 1a liegenden Teil der Seitenzone 15 ausgeht und sich längs der Oberseite 1a in Richtung auf die laterale Begrenzung 4 des p-Basisgebiets 2 erstreckt. Die Halbleiterzone 17 ist durch einen planaren pn-Übergang 18 vom Teil 14 des Halbleiterkörpers 1 getrennt, wobei der pn-Übergang 18 im wesentlichen parallel zur Oberseite 1a verläuft und sich lediglich im Bereich seines rechten Randabschlusses ganz allmählich der Oberseite 1a annähert, die er im Bereich einer senkrecht zur Bildebene verlaufenden Linie 20 erreicht. Die Linie 20 stellt hierbei die laterale Begrenzung der Halbleiterzone 17 dar. Die Dotierungskonzentration der p-leitenden Halbleiterschicht 11 und der Seitenzone 15 sowie die des links von der gestrichelten Linie 19 befindlichen Teils der Halbleiterzone 17 beträgt etwa $10^{18} cm^{-3}$. Rechts von der Linie 19 verringert sich die Dotierungskonzentration ausgehend von diesem Wert in Richtung auf die laterale Begrenzung 20 bis auf etwa $10^{13} cm^{-3}$. Mit Vorteil ist ein n-leitendes Halbleitergebiet 21 etwa in der Mitte zwischen den lateralen Begrenzungen 4 und 20 des p-Basisgebietes 2 bzw. der Halbleiterzone 17 in den Teil 14 des Halbleiterkörpers 1 so eingefügt, daß es sich bis zur Oberseite 1a desselben erstreckt. Dabei kann die Dotierungskonzentration des Halbleitergebiets 21 z.B. $10^{18} cm^{-3}$ betragen. Die in Fig. 1 ersichtlichen Ausnehmungen an der Oberseite 1a von 1 im Bereich der Randabschlüsse der planaren pn-Übergänge 3 und 18 sind lediglich herstellungstechnisch bedingt und werden weiter unten noch näher erläutert.

Bei Zuführung einer Blockierspannung an die Anschlüsse 10, 13 bildet sich an dem in Sperrrichtung vorgespannten pn-Übergang 3 eine Raumladungszone aus, deren obere und untere Begrenzungen durch die gestrichelten Linien 22 und 23 gegeben sind. Wegen des oben beschriebenen Verlaufs des pn-Übergangs im Bereich des Randabschlusses 4 findet eine Aufweitung der Raumladungszone 22 23 an der Oberseite 1a statt, wobei deren Weite an der Oberseite 1a durch den Doppelpfeil 24 gekennzeichnet ist. Diese Weite ist so groß, daß die am pn-Übergang 3 unter dem Einfluß der Blockierspannung auftretende Oberflächenfeldstärke so weit reduziert ist, daß die gewünschte hohe positive Sperrfähigkeit erreicht wird.

Wird eine Sperrspannung an die Anschlüsse 10, 13 gelegt, so bildet sich an dem in diesem Fall in Sperrrichtung vorgespannten pn-Übergang 18 sowie an den ebenfalls in Sperrrichtung vorgespannten pn-Übergängen zwischen den Teilen 11, 15 und 14 eine Raumladungszone aus, die durch die gestrichelten Begrenzungslinien 25 und 26 angedeutet ist. Der Doppelpfeil 27 kennzeichnet die durch den Verlauf des pn-Übergangs 18 erreichte Aufweitung der Raumladungszone an der Oberseite 1a des Halbleiterkörpers 1, die eine Absenkung der im Randbereich 20 des pn-Übergangs 18 auftretenden Oberflächenfeldstärke auf solche Werte mit sich bringt, daß die gewünschte hohe negative Sperrfähigkeit erreicht wird.

Das n-leitende Halbleitergebiet 21, das wesentlich höher dotiert ist als der Teil 14 des Halbleiterkörpers 1, begrenzt die Ausweitung der Raumladungszonen 22, 23 und 25, 26 an der Oberseite 1a. Verzichtet man auf das Gebiet 21, so müssen bei sonst gleichen Bedingungen die lateralen Begrenzungen 4 und 20 weiter auseinandergelegt werden, so daß die sich in diesem Fall weiter in den Teil 14 des Halbleiterkörpers ausdehnenden Raumladungszonen nicht den Zwischenraum zwischen den Begrenzungen 4 und 20 vollständig ausfüllen können.

Bei der Herstellung des Thyristors nach Fig. 1 wird zweckmäßigerweise von einem n-leitenden Halbleiterkörper 1 ausgegangen, wobei gemäß Fig. 2 ein p-Dotierstoff, z.B. A1, in eine von den Grenzflächen von 1 ausgehende Zone, die durch die gestrichelte Linie 28 gegen den übrigen Teil von 1 abgegrenzt ist, eingebracht wird, und zwar mittels eines ersten, auch als "predeposition" bezeichneten Vordiffusionsschritts. Dabei wird eine entsprechende Diffusionsquelle verwendet, die bei einer vorgegebenen Temperatur, z.B. 1060°C, innerhalb eines vorgegebenen Zeitraums, z.B. für eine Dauer von 7 Stunden, den Dotierstoff durch die Grenzflächen in die Zone 28 einbringt. Diesen Vorgang kann man auch als eine Belegun des Halbleiterkörpers 1 im Bereich seiner Grenzflächen mit dem Dotierstoff aus der Gasphase auffassen. Die Zone 28 weist z.B. eine Eindringtiefe von 100 μm und eine randseitige Dotierungskonzentration in unmittelbarer Nähe der Grenzflächen von etwa $10^{19} cm^{-3}$ auf. In einem sich anschließenden Verfahrensschritt wird die Zone 28 in der aus Fig. 2 ersichtlichen Weise strukturiert. Dabei werden in der Zone 28 Ausnehmungen 29 bis 35 vorgesehen. Im einzelnen wird zunächst die Oberseite 1a mit einer Ätzmaske bedeckt, die durch an sich bekannte fotolithografische Schritte so strukturiert wird, daß sie an den Stellen, an denen die Ausnehmungen 29 bis 35 vorgesehen sind, entfernt wird. In einem sich anschließenden Ätzvorgang werden dann die sich bis zur Linie 28 erstreckenden Ausnehmungen 29 bis 35 erzeugt. Bei einer seitlichen kreisförmigen Begrenzung des als Scheibe ausgebildeten Halbleiterkörpers 1 weisen die Bodenflächen der Ausnehmungen 29 bis 35 zweckmäßig die Form von konzentrischen Kreisen auf. Bezeichnet man die Breite der einzelnen Ausnehmungen mit w und den Abstand zweier nebeneinanderliegender Ausnehmungen mit d, so nimmt die Größe d/w für die Ausnehmungen 29 bis 31 mit fortschreitender Annäherung an den Randabschluß 4 jeweils ab. In analoger Weise nimmt die Größe d/w für die Ausnehmungen 32 bis 35 mit fortschreitender Annäherung an den Randabschluß 20 ebenfalls ab. Die Ausnehmung 32 bestimmt dabei den lateralen Abstand des Randabschlusses 4 des p-Basisgebiets 2 vom Rand 20 der Zone 17.

Sodann erfolgt ein auch als Nachdiffusion bezeichneter Temperschritt, bei dem der in Fig. 2 dargestellte Halbleiterkörper unter Entfernung der Diffusionsmaske während einer vorgegebenen Zeitspanne von z.B. 20 Stunden einer Temperatur von etwa 1240°C ausgesetzt wird. Dabei diffundieren die in die Zone 28 eingebrachten Dotierstoffatome aus den gemäß Fig. 2 verbliebenen Teilen der Zone 28 weiter in den Halbleiterkörper 1 ein, so daß schließlich die eingezeichneten pn-Übergänge 3, 18, 36 und 37 entstehen. Hierdurch werden die Halbleiterteile 2, 11, 15 und 17 gemäß Fig. 1 erzeugt. Dabei wird unter dem Teil der Oberseite 1a des Halbleiterkörpers 1, der von den Ausnehmungen 29 bis 35 lateral umfaßt wird, der innere Teil des p-Basisgebiets 2 gebildet. In einem sich anschließenden Diffusionsschritt werden die n-leitenden Gebiete 6 und 21 eingefügt. Es folgt eine Kontaktierung der Gebiete 6, 2 und 11 mit Elektroden 7, 9 und 12.

Das anhand von Fig. 2 beschriebene Herstellungsverfahren entspricht weitgehend dem Verfahren zur Herstellung eines pn-Übergangs, das in der EP-A 0 262 356 angegeben ist.

Fig. 3 verdeutlicht ein anderes Verfahren zur Herstellung eines erfindungsgemäßen Thyristors. Dabei wird die Oberseite 1a des Halbleiterkörpers 1 mit einer Dotierungsmaske M versehen, in der Öffnungen 38 bis 45 vorgesehen sind. Die Öffnungen 38 bis 41 sind mit zunehmender Annäherung an die Linie 4 jeweils kleiner bemessen. Ebenso sind die Öffnungen 42 bis 44 mit zunehmender Annäherung an die Linie 20 jeweils kleiner bemessen. Im einzelnen definiert die Öffnung 38 den inneren Teil des p-Basisgebiets 2, während weitere, wesentlich kleinere Öffnungen 39 bis 41 den Randbereich von 2 definieren. Die randseitige Öffnung 45 definiert den wesentlichen Teil der p-leitenden Halbleiterzone 17, während die wesentlich kleineren Öffnungen 42 bis 44 den Randbereich von 17 definieren. Dabei wird der für die Bildung der Gebiete 2, 11, 15 und 17 benötigte Dotierstoff mittels eines Diffusionsschrittes in den Halbleiterkörpers 1 so eingebracht, daß sich die pn-Übergänge 3 und 18, sowie die zwischen den Teilen 11, 15 und 14 unmittelbar ergeben. Nach dem Entfernen der Dotierungsmaske M werden die Gebiete 6 und 21 in der bereits beschriebenen Weise eingefügt und die Gebiete 6, 2 und 11 mit den Elektroden 7, 9 und 12 versehen. Ein Herstellungsverfahren dieser Art wurde bereits in der EP-A 0 176 778 beschrieben.

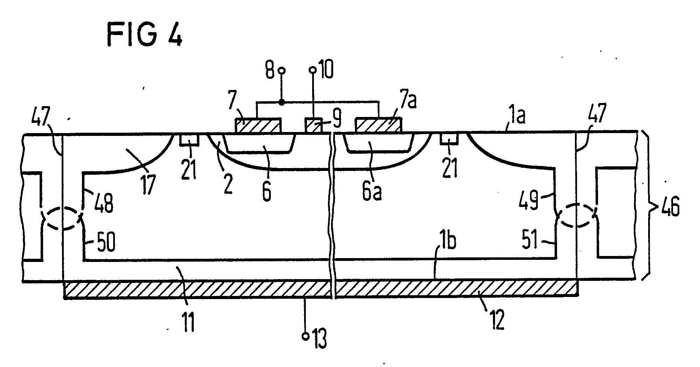

Wird bei der Herstellung von erfindungsgemäßen Thyristoren von einem in Fig. 4 dargestellte, waferartigen, n-leitenden Halbleiterkörper 46 ausgegangen, der für mehrere solcher Thyristoren vorgesehen ist, so werden an den die einzelnen Thyristoren voneinander trennenden Grenzflächen 47 in an sich bekannter Weise p-Trenndiffusionen eingefügt. Hierunter versteht man das maskierte Eindiffundieren eines p-Dotierstoffes, durch das p-Diffusionsgebiete 48 und 49 von der Oberseite 1a sowie 50 und 51 von der Unterseite 1b des Halbleiterkörpers her eingefügt werden. Dabei sind die Eindringtiefen der Gebiete 48 und 50 so groß gewählt, daß sich ein durchgehendes p-leitendes Diffusionsgebiet 48, 50 ergibt. Ebenso bilden die Gebiete 49 und 51 ein durchgehendes Diffusionsgebiet 49, 51. Anschließend können alle im Halbleiterkörper 46 enthalten Thyristoren gleichzeitig den Verfahrensschritten unterzogen werden, die anhand von Fig. 2 oder anhand von Fig. 3 erläutert wurden. In Fig. 4 ist vorausgesetzt, daß die Gebiete 2, 17 und 11 sowie die n-Emittergebiete 6 und 6a gemäß der anhand von Fig. 2 oder Fig. 3 erläuterten Verfahrensschritte erzeugt worden sind. Auch die Gebiete 21 sind hierbei in der bereits beschriebenen Weise eingefügt worden. Im Anschluß daran werden dann die einzelnen Thyristoren entlang der Grenzflächen 47 voneinander getrennt, z.B. durch Laserbestrahlung, durch Sägen oder dergl. Es folgt die Belegung mit den Elektroden 7, 9 und 11, wobei für das n-Emittergebiet 6a ein Elektrodenteil 7a vorgesehen ist, der zusammen mit der Elektrode 7 an den Anschluß 8 gelegt wird. Die an den Trennflächen 47 liegenden Teile der durch das Trennen etwa halbierten p-Diffusionsgebiete 48 und 50 bzw. 49 und 51 bilden bei der in Fig. 4 dargestellten Ausführungsform eines erfindungsgemäßen Thyristors die seitlichen Zonen 15 desselben.

Anstelle der obengenannten Diffusionsschritte können in den erfindungsgemäßen Herstellungsverfahren auch entsprechende Implantationsschritte vorgenommen werden, um die im Halbleiterkörper 1 definierten p-leitenden Gebiete zu definieren. An die Stelle der Trenndiffusionsgebiete 48 bis 51 können insbesondere entsprechende Tiefimplantationen bzw. Hochenergieimplantationen treten.

## Ansprüche

1. Thyristor mit positiver und negativer Sperrfähigkeit, bestehend aus einem mit einer anodenseitigen Elektrode (12) versehenen p-Emitter, einer n-Basis, einer p-Basis und einem mit einer kathodenseitigen Elektrode (7) versehenen n-Emitter, bei dem die p-Basis aus einem p-leitenden Basisgebiet (2) besteht, das in einen n-leitenden Halbleiterkörper (1) an dessen Oberseite (1a) eingefügt ist, bei dem der p-Emitter aus einer in den Halbleiterkörper (1) an dessen Unterseite (1b) eingefügten p-leitenden Halbleiterschicht (11) besteht und bei dem der n-Emitter aus einem oder mehreren in das p-Basisgebiet (2) eingefügten, n-leitenden Halbleitergebieten (6) gebildet ist, **dadurch gekennzeichnet, daß** das p-leitende Basisgebiet (11) durch einen parallel zur Oberseite (1a) des Halbleiterkörpers (1) verlaufenden und sich in seinem Randbereich der Oberseite (1a) allmählich annähernden, ersten planaren pn-Übergang (3) von dem darunterliegenden, die n-Basis bildenden Teil (14) des Halbleiterkörpers getrennt ist und daß sich die p-leitende Halbleiterschicht (11) in einer den Halbleiterkörper seitlich begrenzenden, von der Unterseite bis zur Oberseite reichenden, p-leitenden Seitenzone (15) fortsetzt, welche in eine in den Halbleiterkörper an dessen Oberseite eingefügte, p-leitende Halbleiterzone (17) übergeht, die, ausgehend von dem an der Oberseite liegenden Teil der p-leitenden Seitenzone (15) längs der Oberseite (1a) des Halbleiterkörpers in Richtung auf den Randabschluß (4) des p-Basisgebiets (2) verläuft und durch einen sich der Oberseite (1a) ganz allmählich annähernden, zweiten planaren pn-Übergang (18) von dem unter ihr liegenden Teil (14) des Halbleiterkörpers getrennt ist.

2. Thyristor nach Anspruch 1, **dadurch gekennzeichnet,** daß an der Oberseite (1a) des Halbleiterkörpers (1) zwischen dem Randabschluß (4) des pn-Basisgebiets (2) und der p-leitenden Halbleiterzone (17) ein n-leitendes Gebiet (21) in den die n-Basis bildenden Teil (14) des Halbleiterkörpers (1) eingefügt ist.

3. Verfahren zur Herstellung eines Thyristors nach Anspruch 1, **dadurch gekennzeichnet,** daß von einem n-leitenden Halbleiterkörper (1) ausgegangen wird, daß ein p-Dotierstoff allseitig in eine von den Grenzflächen des Halbleiterkörpers (1) ausgehende Zone (28) eingebracht wird, daß diese Zone (28) durch fotolithografische Schritte und einen sich anschließenden maskierten Ätzvorgang auf der Oberseite des Halbleiterkörpers mit Ausnehmungen (29 bis 35) versehen wird, wobei eine dieser Ausnehmungen (32) den lateralen Abstand des Randabschlusses (4) des p-Basisgebiets (2) vom Rand (20) der p-leitenden Halbleiterzone (17) bestimmt, daß der in die außerhalb dieser Ausnehmungen liegenden Teilen der Zone (28) eingebrachte p-Dotierstoff durch einen Temperschritt tiefer in den Halbleiterkörper eindiffundiert und daß unter dem Teil der Oberseite (1a) des Halbleiterkörpers (1), der von den Ausnehmungen (29 bis 35) lateral umfaßt wird, der innere Teil des p-Basisgebiets (2) gebildet wird, in den ein oder mehrere n-Emittergebiete (6) eingefügt werden.

4. Verfahren zur Herstellung eines Thyristors nach Anspruch 1, **dadurch gekennzeichnet,** daß von einem n-leitenden Halbleiterkörper (1) ausgegangen wird, der an seiner Oberseite (1a) mit einer Dotierungsmaske (M) abgedeckt wird, die mit Öffnungen (38 bis 45) versehen ist, von denen eine erste (38) den inneren Teil des p-Basisgebiets definiert und weitere, wesentlich kleinere Öffnungen (39 bis 41) den Randbereich desselben definieren und von denen eine Zweite, randseitige Öffnung (45) den wesentlichen Teil der p-leitenden Halbleiterzone (17) und weiter, wesentlich kleinere Öffnungen (44 bis 42) den Randbereich der p-leitenden Halbleiterzone (17) definieren, daß ein p-Dotierstoff mittels einer Diffusion oder Implantation in den Halbleiterkörper (1) eingebracht wird, wobei die durch die Maske (M) eingebrachten Dotierstoffatome das p-Basisgebiet (2) und die p-leitende Halbleiterzone (17) mit ihren planaren pn-Übergängen erzeugen, und daß in das p-Basisgebiet ein oder mehrere n-Emittergebiete (6) eingefügt werden.

5. Verfahren zur Herstellung einer Mehrzahl von Thyristoren nach Anspruch 1, **dadurch gekennzeichnet,** daß von einem n-leitenden, waferartigen Halbleiterkörper (46) ausgegangen wird, der mit einer Mehrzahl von die Thyristoren gegeneinander abgrenzenden Trenndiffusionen oder Tiefimplantationen (48 bis 51) versehen wird, daß mehrere oder alle der hierdurch definierten Thyristoren gemeinsam an ihren Oberseiten mit den zugehörigen p-Basisgebieten (2) und p-leitenden Halbleiterzonen (17) sowie an ihren Unterseiten gemeinsam mit den zugehörigen p-Halbleiterschichten (11) versehen werden, daß die Thyristoren anschließend mit den zugehörigen Elektroden versehen werden und daß im Anschluß daran das Trennen der einzelnen Thyristoren in den Bereichen der Trenndiffusionen oder Tiefimplantationen so vorgenommen wird, daß sich Teile der Trenndiffusionen oder Tiefimplantationen jeweils über die gesamten seitlichen Grenzflächen der einzelnen Thyristoren erstrecken.

EP 0 332 955 A2

FIG 1

FIG 2

FIG 3

FIG 4